# EUROPÄISCHE PATENTSCHRIFT

(11) **EP 2 916 634 B1**
(45) Veröffentlichungstag und Bekanntmachung des Hinweises auf die Patenterteilung: **22.08.2018**
(21) Anmeldenummer: 15157503.2
(22) Anmeldetag: 04.03.2015
(51) Int. Cl.: H05K 7/14

(54) **Umrichter, insbesondere mehrphasiger Drehstromumrichter**
CONVERTER, IN PARTICULAR MULTI-PHASE ALTERNATING CURRENT CONVERTER
CONVERTISSEUR, NOTAMMENT REDRESSEUR MULTIPHASES

(30) Priorität: 07.03.2014 DE 102014103109
(43) Veröffentlichungstag der Anmeldung: 09.09.2015
(73) Patentinhaber: STILL GmbH, 22113 Hamburg (DE)
(72) Erfinder: Schettgen, Nils, 22559 Hamburg (DE)
(74) Vertreter: Patentship Patentanwaltsgesellschaft mbH

(56) Entgegenhaltungen:
- EP-A1- 2 584 690
- EP-A2- 2 149 973
- EP-A2- 2 328 392
- JP-A- 2003 299 364
- US-A1- 2010 327 654
- US-B1- 6 380 728

## Beschreibung

Die Erfindung betrifft einen Umrichter, vor allem einen mehrphasigen Drehstromumrichter. Insbesondere betrifft die Erfindung einen Umrichter, etwa einen mehrphasigen Drehstromumrichter, mit einem Gleichspannungszwischenkreis, Leistungsausgängen und mindestens einen Leistungshalbleiter, wobei Leistungsstromanschlüsse des Gleichspannungszwischenkreises sowie der Leistungsausgänge in einem Gehäuseabschnitt aus einem Gehäuse des Umrichters herausgeführt sind.

Ein gattungsgemäßer Umrichter ist aus der EP 2 328 392 A2 bekannt.

Mehrphasige Umrichter, beispielsweise dreiphasige Wechselrichter oder Frequenzumrichter, werden zur Speisung von mehrphasigen elektrischen Antriebsmaschinen aus einer Gleichspannungsquelle verwendet. Eingesetzt werden derartige Umrichter beispielsweise als Frequenzumrichter, die aus einer Gleichspannungsquelle einen Fahrmotor, beispielsweise einen Asynchronmotor, eines elektrisch angetriebenen Fahrzeugs, etwa eines Flurförderzeugs, ansteuern.

Eine Gleichspannungsquelle, etwa eine Traktionsbatterie oder eine Kombination aus einem Verbrennungsmotor mit einem Generator, gegebenenfalls auch eine sonstige Gleichspannungsquelle wie eine Brennstoffzelle, dient als Gleichspannungszwischenkreis, aus dem der Umrichter versorgt wird und mehrphasigen Strom zum Antrieb einer elektrischen Arbeitsmaschine erzeugt. Dabei kann als Generator bei einer Gleichspannungsquelle, die aus einem Verbrennungsmotor mit einem Generator besteht, ein Gleichspannungsgenerator oder ein Drehstromgenerator eingesetzt werden, dessen erzeugter Drehstrom in einem Gleichrichter gleichgerichtet wird.

Bei solchen Umrichter für insbesondere einen Fahrantrieb werden von den Halbleitern sehr große Ströme geschaltet und entsteht viel Abwärme durch die Verlustleistung. Daher ist es ein bekannter Aufbau, die Halbleiter direkt an einem Kühlkörper anzuordnen der einen Teil des Gehäuses des Umrichters bildet. Um zugleich die hohen Ströme des Gleichspannungszwischenkreises über Leistungsstromanschlüsse zuführen sowie die einzelnen Phasen des mehrphasigen Stromes ableiten zu können, werden häufig zusätzliche Stromschienen eingesetzt. Dadurch können erst große Leiterquerschnitte erreicht werden, die mit Leiterbahnen auf Platinen bzw. Substraten nur schwer zu verwirklichen sind.

Auch wird dadurch die Zu- und Abführung der Leistungsstromanschlüsse erleichtert, wenn oberhalb der Halbleiter in einer zweiten Ebene auf einer weiteren Platine die anderen Bauteile des Umrichters, wie insbesondere die Glättungskondensatoren angeordnet werden. In diesem Fall ist es möglich, die Leistungsstromanschlüsse bzw. Stromschienen durch Aussparungen dieser Platine in der zweiten Ebene hindurch direkt nach unten zu den Leistungshalbleitern, insbesondere Leistungstransistoren zu führen, etwa durch Schraubenbolzen oder Druckhülsen, die bis zu einer unteren, ersten Platine mit den Leistungstransistoren, die an dem Kühlkörper angeordnet ist, hindurchgeführt sind.

Durch die Verwendung von Stromschienen ist es auch möglich, die Ausbildung von elektromagnetischen Feldern innerhalb des Umrichtergehäuses in einem gewissen Maß zu steuern.

Für die Steuerung des Umrichters sind Stromsensoren erforderlich, die die in den Leistungsstromanschlüssen fließenden Ströme erfassen. Hierfür sind Stromsensorkerne bekannt, die als weichmagnetisches Material, beispielsweise Blechpakete, den Stromleiter umschließen und einen Spalt aufweisen. In diesem Spalt wird dann ein Magnetsensor, insbesondere ein Hallsensor angeordnet, über den indirekt über die sich bildenden Magnetfelder die fließenden Ströme erfasst werden können.

Nachteilig an diesem Stand der Technik ist, dass bei der Endmontage des Umrichters die Stromschienen wie auch die Stromsensoren als einzelne Bauelemente bzw. nachträglich in den bereits teilmontierten Umrichter eingebracht und befestigt werden müssen. Dadurch entsteht erheblicher Aufwand angefangen von der notwendigen Lagerhaltung der diversen einzelnen Teile bis zur erforderlichen Arbeitszeit im Rahmen der Endmontage. Auch ist es erstrebenswert, die eigentlichen Sensorelemente, insbesondere die bereits beschriebenen Hallsensoren, auf einer im Regelfall vorgesehenen zusätzlichen Steuerplatine anzuordnen und zu befestigen, etwa durch auflöten oder verkleben. Nach dem Stand der Technik ist dann jedoch eine einfache Montage durch Einsetzen der Steuerplatine nicht ohne weiteres möglich, wenn diese Sensorelemente in den Spalt der Stromsensorkerne eingesetzt werden müssen.

Weiterhin ist bekannt, einen unteren Gehäuseteil als umlaufenden Druckrahmen so vorzusehen, dass dieser die erste Platine mit den Leistungshalbleitern gegen den Kühlkörper drücken kann.

Aus der US 2006/0007721 A1 ist ein Leistungsumrichter bekannt, bei dem Leiterelemente in einen Kunststoffrahmen im Spritzgussverfahren eingefügt sind. Nachteilig an diesem Stand der Technik ist, dass keine Lösung für eine effiziente und einfache Montage der Stromsensoren offenbart wird.

Aus der US 2010/327654 A1 ist ein Umrichter bekannt, bei dem die Leistungsstromanschlüsse in einem AC-Anschlussgehäuse angeordnet sind. In dem AC-Anschlussgehäuse ist weiterhin ein Stromsensor angeordnet und eingebaut, der den in den Leistungsstromanschlüssen fließenden Strom erfasst.

Der vorliegenden Erfindung liegt die Aufgabe zugrunde, einen Umrichter, insbesondere einen mehrphasigen Drehstromumrichter, zur Verfügung zu stellen, der die oben genannten Nachteile vermeidet und bei dem eine effiziente und einfache Montage möglich ist.

Diese Aufgabe wird durch einen Umrichter mit den Merkmalen des unabhängigen Patentanspruchs 1 gelöst. Vorteilhafte Weiterbildungen der Erfindung sind in den Unteransprüchen angegeben.

Die Aufgabe wird erfindungsgemäß dadurch gelöst, dass bei einem Umrichter, insbesondere mehrphasiger Drehstromumrichter, mit einem Gleichspannungszwischenkreis, Leistungsausgängen und mindestens einen Leistungshalbleiter, wobei Leistungsstromanschlüsse des Gleichspannungszwischenkreises sowie der Leistungsausgänge in einem Gehäuseabschnitt aus einem Gehäuse des Umrichters herausgeführt sind, der Gehäuseabschnitt aus isolierendem Spritzgussmaterial besteht und die Leistungsstromanschlüsse von dem Spritzgussmaterial in einer Durchführung des Gehäuseabschnitts umspritzt und mit diesem fest verbunden sind, wobei ein Stromsensorring mindestens einen der Leistungsstromanschlüsse umschließend zumindest teilweise in dem Spritzgussmaterial des Gehäuseabschnitts angeordnet ist.

Dadurch ergeben sich vorteilhaft eine Vormontagebaugruppe und eine Reduzierung von Kosten sowie Zeitaufwand. Die Einheit aus Gehäuseabschnitt mit den Leistungsstromanschlüssen sowie sich daran eventuell anschließende Stromschienen kann als gesamte Vormontageeinheit bei der Montage des Umrichters montiert werden. Bevorzugt wird dabei der Gehäuseabschnitt von oben auf den Kühlkörper mit der oder den Platinen aufgesetzt. Es müssen dann lediglich Kontaktstellen bzw. Kontaktpositionen der Leistungsstromanschlüsse oder Stromschienen angeschlossen werden. Dadurch müssen weniger Bauteile in der Produktion zugeführt, gelagert werden und montiert werden. Indem die Stromsensorringe in dem Gehäuseabschnitt angeordnet sind und nicht einzelnen um Stromschienen oder Leistungsstromanschlüsse herum gefädelt werden müssen, ergibt sich eine erhebliche Vereinfachung der Montage. Zusätzlich wird der zur Verfügung stehende Bauraum besser ausgenutzt, wenn die Stromsensorringe in der Gehäusewand angeordnet sind. Dabei können einer oder mehrere der Leistungsstromanschlüsse jeweils mit einem Stromsensorring versehen sein. Auch ergibt sich eine bessere Abdichtung der Durchführung der Leistungsstromanschlüsse, da das Spritzgussmaterial, insbesondere wenn es sich um ein Kunststoff handelt, beim Abkühlen als Thermoplast bzw. beim Aushärten als Duroplast die Leistungsstromanschlüsse gasdicht umschließt. Die einzelnen Komponenten werden bei der Herstellung des Gehäuseabschnitts in das Spritzgusswerkzeug eingelegt und mit dem Spritzgussmaterial umspritzt.

Der Stromsensorring kann vollständig in dem Spritzgussmaterial angeordnet sein.

Vorteilhaft besteht der Stromsensorring aus einem Blechpaket.

In einer günstigen Ausführungsform weist der Sensorring einen Spalt auf, in den ein Sensorelement, insbesondere ein Hallsensor, angeordnet werden kann.

Vorteilhaft ist in dem Spalt eine Ausnehmung in dem Spritzgussmaterial angeordnet.

Dadurch entsteht vorteilhaft eine Ausnehmung, in dem ein Sensorelement angeordnet werden kann, das sich dann direkt in dem magnetischen Fluss des Sensorrings befindet, durch den die Stromstärke in dem Leistungsstromanschluss bestimmt werden kann.

Die Ausnehmung kann zu einer Innenseite des Gehäuses hin orientiert ist, so dass auf einer Steuerplatine angeordnete Sensorelemente in Montagelage der Steuerplatine in die Ausnehmungen ragen können.

Insbesondere kann dadurch auch bei einer Mehrzahl von Stromsensoren durch das Einsetzen einer einzigen Steuerplatine eine Montage erfolgen. Eine bekannte Montageposition der Steuerplatine ist senkrecht in Bezug auf die Platine der Leistungshalbleiter stehend am Gehäuserand angeordnet. Die zumeist als Hallsensoren ausgeführten Sensorelemente können dann gleichzeitig alle eingeführt werden, wenn die Steuerplatine von oben in eine entsprechende Führung in dem Gehäuseabschnitt oder dem Gehäuse eingefädelt wird.

Vorteilhaft bildet der Gehäuseabschnitt einen umlaufenden Rahmen.

Dieser Rahmen bildet dann beispielsweise einen unteren Gehäuseabschnitt, der zusammen mit einem Deckel und dem Kühlkörper das Gehäuse bildet, wobei der Deckel nur zum Verschluss und zur Abdeckung dient.

Der Rahmen kann als Druckrahmen eine Platine mit dem mindestens einen Leistungshalbleiter auf einen Kühlkörper.

Hierzu ist vorteilhaft eine Abstufung oder ein Absatz am unteren Rand des Rahmens vorgesehen, der auf die Oberseite der Platine der Leistungshalbleiter drückt.

In vorteilhafter Ausführung ist der Rahmen auf seiner Unter- und/oder Oberseite als Montageeinheit mit einer aufgespritzten Dichtmasse versehen.

Eine solche, beispielsweise als Elastomer oder elastischer Kunststoff, aufgebrachte Dichtmasse ist dann bereits Bestandteil der Montageeinheit des Rahmens. Das Aufbringen eines Dichtmittels oder Einlegen einer Dichtung bei der Montage entfällt. Gleichzeitig kann das Eindringen von Feuchtigkeit und Schmutz sicher verhindert werden, da das Dichtmittel mit großer und gleichbleibender Genauigkeit in der Produktion des Rahmens aufgebracht werden kann.

Die Leistungsstromanschlüsse im Gehäuseinneren können als Stromschienen ausgeführt sein, die bis zu einer Kontaktposition geführt sind.

In einer günstigen Weiterbildung können die Stromschienen an der Kontaktposition eine Druckkraft in Richtung einer Platine ausüben.

Da die Leistungsstromanschlüsse und über diese die Stromschienen fest in dem Gehäuseabschnitt durch die Spritzgussverbindung gehalten werden, kann eine Druckkraft ausgeübt werden, wenn beispielsweise der Gehäuseabschnitt, etwa in Form eines Rahmens, auf dem Kühlkörper befestigt wird. In diesem Fall ist es möglich, dass an den Kontaktpositionen eine auf den Kühlkörper gerichtete bzw. auf eine Platine gerichtete Kraft ausgeübt wird, die die Platine auf den Kühlkörper presst. Dies ist auch unabhängig davon möglich, ob Stromsensoren in dem Gehäuseabschnitt integriert sind an den Durchführungen oder nicht. Es wäre daher auch eine Ausführungsform denkbar, bei der ohne Stromsensoren nur durch die Durchführung und Befestigung der Leistungsstromanschlüsse durch Spritzguss in dem Gehäuseabschnitt über die Stromschienen eine Druckkraft ausgeübt werden kann.

Vorteilhaft ist das Spritzgussmaterial ein Kunststoff.

Dabei sind sowohl Duroplaste, wie auch Thermoplaste geeignet.

Der Kunststoff kann ein faserverstärkter Kunststoff sein.

Vorteilhaft ist in dem Gehäuseabschnitt eine Steckverbindung für Signalleitungen eingespritzt.

Ganz allgemein ergibt sich die Möglichkeit, mehrere Funktionen und Funktionsgruppen, die bisher durch zusätzliche Halter innerhalb des Gehäuses befestigt sind, in die Struktur des Gehäuseabschnitts bzw. eines als Rahmen ausgebildeten Gehäuseabschnitts zu integrieren. Dadurch kann bei Bauteilen die bekannte Verwendung von Leiterplattenhaltern, Schraubverbindungen sowie Klebstoffen innerhalb des Gehäuses vermieden werden.

In einer vorteilhaften Weiterbildung sind Schraubenbolzen als Anschlussbolzen für die Leistungsstromanschlüsse auf der Außenseite des Gehäuseabschnitts eingespritzt, wobei der Schraubenbolzen durch eine Öffnung des Leistungsstromanschlusses geführt ist und der Leistungsstromanschluss eine freiliegende Kontaktfläche aufweist.

Dadurch ist der Schraubenbolzen in dem Gehäuseabschnitt fest gehalten und sein freiliegender Gewindeabschnitt wird durch die Öffnung des Leistungsstromanschlusses geführt, wobei auf der dem Gehäuse abgewandten Seite des Leistungsstromanschlusses eine frei liegende Kontaktfläche ist. Wird daher ein Anschlussauge eines Anschlusskabels um den Gewindeabschnitt gelegt, kann durch Verschrauben dieses gegen die Kontaktfläche sicher und zuverlässig gepresst werden und es ergibt sich ein guter elektrischer Kontakt.

Weitere Vorteile und Einzelheiten der Erfindung werden anhand der in den schematischen Figuren dargestellten Ausführungsbeispiele näher erläutert. Hierbei zeigt
- Fig. 1: eine Perspektivansicht ein Ausführungsbeispiel des Gehäuseabschnitts eines erfindungsgemäßen Umrichters,
- Fig. 2: eine Schnittansicht in der Ebene einer Gehäusewand des Gehäuseabschnitts der Fig. 1,
- Fig. 3: eine weitere Schnittansicht durch die Gehäusewand des Gehäuseabschnitts der Fig. 1 an der Durchführung eines Leistungsstromanschlusses,
- Fig. 4: eine weitere Schnittansicht durch die Gehäusewand des Gehäuseabschnitts der Fig. 1 an der Durchführung eines Leistungsstromanschlusses und
- Fig. 5: eine Sprengbildansicht des Gehäuseabschnitts der Fig. 1.

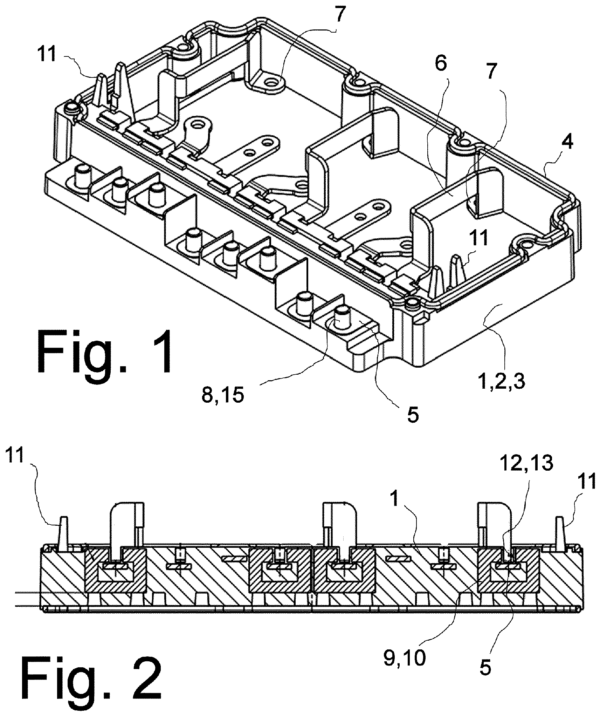

Die Fig. 1 zeigt eine Perspektivansicht eines Ausführungsbeispiels des Gehäuseabschnitts 1 eines erfindungsgemäßen Umrichters, der nicht weiter dargestellt ist. Der Gehäuseabschnitt 1 ist als Rahmen 2 ausgeführt, der als Montageeinheit 3 auf seiner Oberseite mit einer aufgespritzen Dichtmasse 4 versehen ist. Ebenso ist auf der hier nicht sichtbaren Unterseite des Rahmens 2 eine Dichtmasse aufgespritzt. Der Rahmen 2 besteht aus einem Kunststoff als Spritzgussmaterial, bevorzugt einem faserverstärkten Kunststoff. Leistungsstromanschlüsse 5 sind an Durchführungen in dem Gehäuseabschnitt 1 mit der Spritzgussmasse umspritzt und nach innen geführt. Dabei setzen sich die Leistungsstromanschlüsse als Stromschienen 6 fort. In dem Gehäuseabschnitt 1 ebenfalls im Spritzgussverfahren befestigte Anschlussbolzen 15 sind mit einem Gewindeabschnitt 8 jeweils durch eine Öffnung des jeweiligen Leistungsstromanschlusses 5 geführt. An den Enden der Stromschienen 6 befinden sich Kontaktpositionen 7. Da die Leistungsstromanschlüsse 5 durch den Spritzguss mit dem Gehäuseabschnitt 1 fest verbunden sind, können die mit diesen verbundenen, insbesondere beispielsweise einteilig ausgeführten, Stromschienen 6 eine nach unten gerichtete Druckkraft in der Montageposition des Gehäuseabschnitts 1 ausüben. Der Gehäuseabschnitt 1 weist weiterhin noch zwei Führungen 11 für eine Steuerplatine auf, so dass eine nicht dargestellte Steuerplatine in diese Führungen 11 eingesetzt und parallel zu der Gehäusewand sowie senkrecht orientiert am Gehäuserand Ihnen befestigt werden kann.

Die die Fig. 2 zeigt eine Schnittansicht in der Ebene einer Gehäusewand des Gehäuseabschnitts 1 der Fig. 1. Einige der Leistungsstromanschlüsse 5 werden von Stromsensorringen 9, die aus Blechpaketen 10 bestehen, in der Ebene der Gehäusewand umschlossen. Dabei sind die Stromsensorringe 9 in dem Spritzgussmaterial der Gehäusewand eingebettet. In einem Spalt 12 befindet sich auch eine Ausnehmung 13 des Spritzgussmaterials, so dass hier einen Hallsensor als Sensormittel eingesetzt werden kann. Dies kann erfolgen wenn die Steuerplatine über die gesamte Längserstreckung der Seitenwand senkrecht orientiert in den Führungen 11 sich befindet und Hallsensoren als Sensormittel an den entsprechenden Stellen der Steuerplatine angeordnet sind.

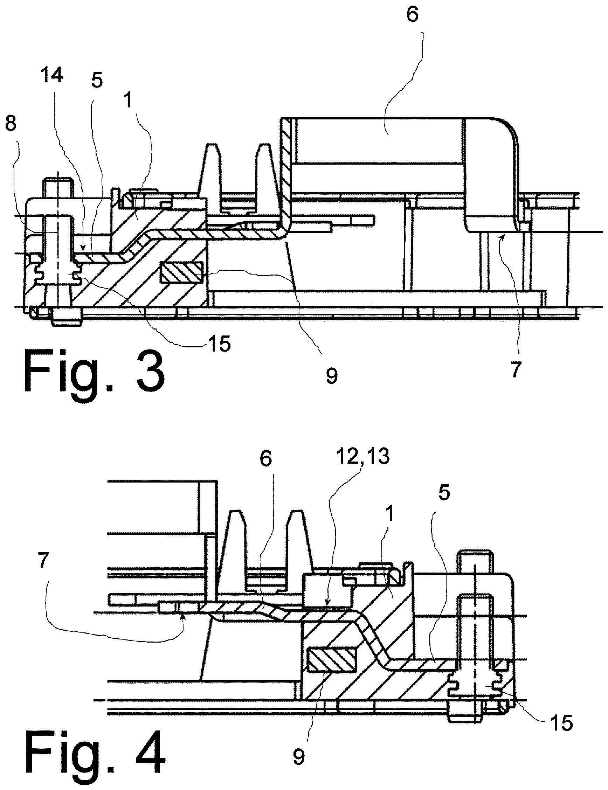

Die Fig. 3 zeigt eine weitere Schnittansicht durch die Gehäusewand des Gehäuseabschnitts 1 der Fig. 1 an der Durchführung eines Leistungsstromanschlusses 5. Der Anschlussbolzen 15 ist in das Spritzgussmaterial eingefügt und erstreckt sich mit seinem Gewindeabschnitt 8 durch eine Öffnung des Leistungsstromanschlusses 5, wobei auf der Oberseite eine freie Kontaktfläche 14 sich befindet. Der Leistungsstromanschluss 5 ist in der Gehäusewand im Bereich der Durchführung von dem Stromsensorring 9 umschlossen und setzt sich als Stromschiene 6 bis zu der Kontaktposition 7 fort.

Die Fig. 4 zeigt eine weitere Schnittansicht durch die Gehäusewand des Gehäuseabschnitts 1 der Fig. 1 an der Durchführung eines Leistungsstromanschlusses 5 mit dem Anschlussbolzen 15 sowie dem Stromsensorring 9 und einer nur kurz ausgeführten Stromschiene 6 bis zu der Kontaktposition 7. In der Schnittebene liegt in der Darstellung auch die Ausnehmung 13 für den Spalt 12.

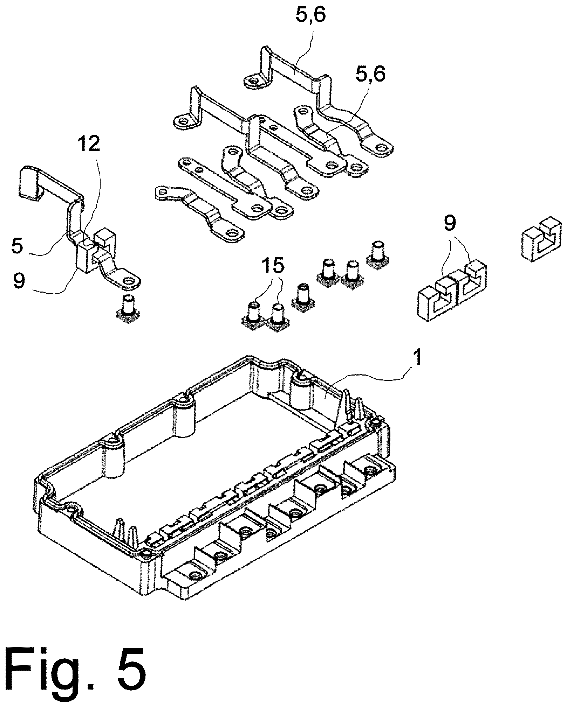

Die Fig. 5 zeigt eine Sprengbildansicht des Gehäuseabschnitts 1 der Fig. 1. Dabei sind die Anschlussbolzen 15, die Stromsensorringe 9 und die Leistungsstromanschlüsse 5 und Stromschienen 6 getrennt dargestellt. In der links abgesetzten Darstellung ist ein Leistungsstromanschluss 5 mit einem Stromsensorring 9 in der Montageposition getrennt von dem Gehäuseabschnitt 1 dargestellt. Dabei umschließt der Stromsensorring 9 den Leistungsstromanschluss 5 bis auf den Spalt 12 vollständig. Beim Spritzgießen des Gehäuseabschnitts 1 werden die Anschlussbolzen 15, die Stromsensorringe 9 und die Leistungsstromanschlüsse 5 in die Spritzgussform eingelegt und miteinander verbunden.

## Patentansprüche

1. Umrichter, insbesondere mehrphasiger Drehstromumrichter, mit einem Gleichspannungszwischenkreis, Leistungsausgängen und mindestens einen Leistungshalbleiter, wobei Leistungsstromanschlüsse (5) des Gleichspannungszwischenkreises sowie der Leistungsausgänge in einem Gehäuseabschnitt (1) aus einem Gehäuse des Umrichters herausgeführt sind,
**dadurch gekennzeichnet,**
**dass** der Gehäuseabschnitt (1) aus isolierendem Spritzgussmaterial besteht und die Leistungsstromanschlüsse (5) von dem Spritzgussmaterial in einer Durchführung des Gehäuseabschnitts (1) umspritzt und mit diesem fest verbunden sind,
wobei ein Stromsensorring (9) mindestens einen der Leistungsstromanschlüsse (5) umschließend zumindest teilweise in dem Spritzgussmaterial des Gehäuseabschnitts (1) angeordnet ist.

2. Umrichter nach Anspruch 1,
**dadurch gekennzeichnet,**
**dass** der Stromsensorring (9) vollständig in dem Spritzgussmaterial angeordnet ist.

3. Umrichter nach Anspruch 1 oder 2,
**dadurch gekennzeichnet,**
**dass** der Stromsensorring (9) aus einem Blechpaket (10) besteht.

4. Umrichter nach einem der Ansprüche 1 bis 3,
**dadurch gekennzeichnet,**
**dass** der Sensorring (9) einen Spalt (12) aufweist, in den ein Sensorelement, insbesondere ein Hallsensor, angeordnet werden kann.

5. Umrichter nach Anspruch 4,
**dadurch gekennzeichnet,**
**dass** in dem Spalt (12) eine Ausnehmung (13) in dem Spritzgussmaterial angeordnet ist.

6. Umrichter nach Anspruch 5,
**dadurch gekennzeichnet,**
**dass** die Ausnehmung (13) zu einer Innenseite des Gehäuses hin orientiert ist, so dass auf einer Steuerplatine angeordnete Sensorelemente in Montagelage der Steuerplatine in die Ausnehmungen (13) ragen können.

7. Umrichter nach einem der Ansprüche 1 bis 6,
**dadurch gekennzeichnet,**
**dass** der Gehäuseabschnitt (1) einen umlaufenden Rahmen (2) bildet.

8. Umrichter nach Anspruch 7,
**dadurch gekennzeichnet,**
**dass** der Rahmen (2) als Druckrahmen eine Platine mit dem mindestens einen Leistungshalbleiter auf einen Kühlkörper drückt.

9. Umrichter nach Anspruch 7 oder 8,
**dadurch gekennzeichnet,**
**dass** der Rahmen (2) auf seiner Unter- und/oder Oberseite als Montageeinheit (3) mit einer aufgespritzten Dichtmasse (4) versehen ist.

10. Umrichter nach Anspruch 7 oder 8,
**dadurch gekennzeichnet,**
**dass** die Leistungsstromanschlüsse (5) im Gehäuseinneren als Stromschienen (6) ausgeführt sind, die bis zu einer Kontaktposition (7) geführt sind.

11. Umrichter nach Anspruch 10,
**dadurch gekennzeichnet,**
**dass** die Stromschienen (6) an der Kontaktposition (7) eine Druckkraft in Richtung einer Platine ausüben können.

12. Umrichter nach einem der Ansprüche 1 bis 11,
**dadurch gekennzeichnet,**
**dass** das Spritzgussmaterial ein Kunststoff ist.

13. Umrichter nach Anspruch 12,
**dadurch gekennzeichnet,**
**dass** der Kunststoff ein faserverstärkter Kunststoff ist.

14. Umrichter nach einem der Ansprüche 1 bis 13,
**dadurch gekennzeichnet,**
**dass** in dem Gehäuseabschnitt (1) ein Steckverbindung für Signalleitungen eingespritzt ist.

15. Umrichter nach einem der Ansprüche 1 bis 14,
**dadurch gekennzeichnet,**
**dass** Schraubenbolzen als Anschlussbolzen (15) für die Leistungsstromanschlüsse (5) auf der Außenseite des Gehäuseabschnitts (1) eingespritzt sind, wobei der Schraubenbolzen durch eine Öffnung des Leistungsstromanschlusses (5) geführt ist und der Leistungsstromanschluss eine freiliegende Kontaktfläche (14) aufweist.

## Claims

1. Converter, in particular polyphase three-phase converter, comprising a DC voltage intermediate circuit, power outputs and at least one power semiconductor, wherein electrical power connections (5) of the DC voltage intermediate circuit and of the power outputs in a housing section (1) are led through out of a housing of the converter, **characterized in that** the housing section (1) consists of insulating injection-moulded material and the electrical power connections (5) are injection-moulded by the injection-moulded material in a bushing of the housing section (1) and are fixedly connected thereto, wherein a current sensor ring (9) enclosing at least one of the electrical power connections (5) is arranged at least partly in the injection-moulded material of the housing section (1).

2. Converter according to Claim 1, **characterized in that** the current sensor ring (9) is arranged completely in the injection-moulded material.

3. Converter according to Claim 1 or 2, **characterized in that** the current sensor ring (9) consists of a laminated core (10).

4. Converter according to one of Claims 1 to 3, **characterized in that** the sensor ring (9) has a gap (12), in which a sensor element, in particular a Hall sensor, can be arranged.

5. Converter according to Claim 4, **characterized in that**, in the gap (12), a recess (13) is arranged in the injection-moulded material.

6. Converter according to Claim 5, **characterized in that** the recess (13) is oriented towards an inner side of the housing so that sensor elements arranged on a control board can project into the recesses (13) in the mounted position of the control board.

7. Converter according to one of Claims 1 to 6, **characterized in that** the housing section (1) forms a circumferential frame (2).

8. Converter according to Claim 7, **characterized in that** the frame (2), as a pressure frame, presses a circuit board with the at least one power semiconductor onto a heatsink.

9. Converter according to Claim 7 or 8, **characterized in that** the frame (2) is provided with a sprayed-on sealing compound (4) on the bottom and/or top side thereof as a mounted unit (3).

10. Converter according to Claim 7 or 8, **characterized in that** the electrical power connections (5) in the housing interior are embodied as busbars (6), which are conducted up to a contact position (7).

11. Converter according to Claim 10, **characterized in that** the busbars (10) at the contact position (7) can exert a compressive force in the direction of a circuit board.

12. Converter according to one of Claims 1 to 11, **characterized in that** the injection-moulded material is a plastic.

13. Converter according to Claim 12, **characterized in that** the plastic is a fibre-reinforced plastic.

14. Converter according to one of Claims 1 to 13, **characterized in that** a plug connection for signal lines is injection-moulded in the housing section (1).

15. Converter according to one of Claims 1 to 14, **characterized in that** threaded bolts as connection bolts (15) for the electrical power connections (5) are injection-moulded on the outer side of the housing section (1), wherein the threaded bolt is conducted through an opening of the electrical power connection (5) and the electrical power connection has an exposed contact surface (14).

## Revendications

1. Convertisseur, notamment redresseur polyphasé, comportant un circuit tampon à tension continue, des sorties de puissance et au moins un semi-conducteur de puissance, dans lequel les bornes de courant de puissance (5) du circuit tampon à tension continue et les sorties de puissance sont extraites d'un boîtier du convertisseur dans une section de boîtier (1),
**caractérisé en ce que** la section de boîtier (1) est constituée d'un matériau de moulage par injection isolant et **en ce que** les bornes de courant de puissance (5) sont encapsulées dans le matériau de moulage par injection dans une traversée de la section de boîtier (1) et sont fermement reliées à celle-ci,
dans lequel un anneau de détection de courant (9) entourant au moins l'une des bornes de courant de puissance (5) est disposé au moins en partie dans le matériau de moulage par injection de la section de boîtier (1).

2. Convertisseur selon la revendication 1,
**caractérisé en ce que** l'anneau de détection de courant (9) est entièrement disposé dans le matériau de moulage par injection.

3. Convertisseur selon la revendication 1 ou 2,
**caractérisé en ce que** l'anneau de détection de courant (9) est constitué d'un empilement de feuilles (10).

4. Convertisseur selon l'une des revendications 1 à 3,
**caractérisé en ce que** l'anneau de détection (9) présente un entrefer (12) dans lequel peut être disposé un élément de détection, notamment un capteur à effet Hall.

5. Convertisseur selon la revendication 4,
**caractérisé en ce qu'**un évidement (13) est formé dans le matériau de moulage par injection dans l'entrefer (12).

6. Convertisseur selon la revendication 5,
**caractérisé en ce que** l'évidement (13) est orienté vers la face interne du boîtier de manière à ce que des éléments de détection disposés sur une carte de commande puissent faire saillie dans les évidements (13) à la position de montage de la carte de commande.

7. Convertisseur selon l'une des revendications 1 à 6,
**caractérisé en ce que** la section de boîtier (1) forme un châssis périphérique (2).

8. Convertisseur selon la revendication 7,
**caractérisé en ce que** le châssis (2), en tant que châssis de pression, repousse une carte comportant au moins un semi-conducteur de puissance sur un corps de refroidissement.

9. Convertisseur selon la revendication 7 ou 8,
**caractérisé en ce que** le châssis (2) est pourvu sur sa face inférieure et/ou supérieure comme unité de montage (3) d'une masse d'étanchéité (4) appliquée par pulvérisation.

10. Convertisseur selon la revendication 7 ou 8,
**caractérisé en ce que** les bornes de courant de puissance (5) sont réalisées à l'intérieur du boîtier sous la forme de rails conducteurs (6) qui sont guidés jusqu'à une position de contact (7).

11. Convertisseur selon la revendication 10,
**caractérisé en ce que** les rails conducteurs (6) peuvent exercer une force de pression orientée vers une carte à la position de contact (7).

12. Convertisseur selon l'une des revendications 1 à 11,
**caractérisé en ce que** le matériau de moulage par injection est une matière plastique.

13. Convertisseur selon la revendication 12,
**caractérisé en ce que** la matière plastique est une matière plastique renforcée par des fibres.

14. Convertisseur selon l'une des revendications 1 à 13,
**caractérisé en ce qu'**une connexion enfichable destinée aux lignes de signaux est injectée dans la section de boîtier (1).

15. Convertisseur selon l'une des revendications 1 à 14,
**caractérisé en ce que** des boulons filetés sont injectés en tant que boulons de raccordement (15) destinés aux bornes de courant de puissance (5) sur la face externe de la section de boîtier (1), dans lequel les boulons filetés sont guidés à travers une ouverture ménagée dans la borne de courant de puissance (5) et **en ce que** la borne de courant de puissance présente une surface de contact (14) exposée.
